Europäisches Patentamt

European Patent Office

Office européen des brevets

(11) Publication number: **0 431 862 A2**

# (12) EUROPEAN PATENT APPLICATION

(21) Application number: **90313087.0**

(22) Date of filing: **03.12.90**

(51) Int. Cl.⁵: **H03K 5/24**

(30) Priority: **06.12.89 US 446741**

(43) Date of publication of application:
**12.06.91 Bulletin 91/24**

(84) Designated Contracting States:
**DE FR GB IT NL**

(71) Applicant: **TEXAS INSTRUMENTS
INCORPORATED**
**13500 North Central Expressway**
**Dallas Texas 75265(US)**

(72) Inventor: **Bhuva, Rohit L.**
**1416 Geneva Lane**
**Plano, Texas 75075(US)**
Inventor: **Herrington, Scott Kelly**
**5555 N.E. Moore Ct.**
**Hillsboro, Oregon 97124(US)**

(74) Representative: **Abbott, David John et al**
**Abel & Imray Northumberland House 303-306**
**High Holborn**
**London, WC1V 7LH(GB)**

(54) **Sense circuitry.**

(57) A programmable array logic (PAL) 46) comprises input lines (20) connected to product lines (22) via FAMOS transistors (24). The product line (22) is selectively connected to a sense node (50) through a N-channel transistor (48) which is controlled by an ITD signal. The sense node (50) is pulled high in standby node by N-channel transistors (52,54). A latch (56) stores the state of sense node (50) responsive to the ITD signal.

FIG. 4

SENSE CIRCUITRY

TECHNICAL FIELD OF THE INVENTION

This invention relates in general to integrated circuits, and more particularly to sense circuitry.

BACKGROUND OF THE INVENTION

Sense amplifiers are used to detect the logic state of a node (hereinafter, the "product line") in a CMOS programmable array logic (PAL) device. In an EPAL (electrically programmable array logic), a number of programmable switches, typically FAMOS transistors, have drains connected to the product lines and sources connected to ground. The FAMOS transistors are addressed or deaddressed by inputs to the EPAL connected to the gates of the FAMOS transistors. FAMOS cells function like normal N-channel MOS transistors when in the erased state. Thus, when the gate of the cell is addressed (logical "1" at the gate), the device is "on" and the drain of the cell is a logical "0". Similarly, if the gate of the cell is not addressed (a logical "0" at the gate), the transistor is not conducting and the drain of the cell is at a logical "1". Whenever a FAMOS cell is programmed, the threshold of the cell is shifted to a high level, such that the transistor will not turn on under normal operation. The drain of the programmed FAMOS cell will always be a logical "1".

Logically, the FAMOS cell acts as an inverter of the input data to the product term. Additionally, because the drains of the FAMOS cells are tied together, a logical "0" will predominate over any number of logical "1"s. This is an "AND" function of inverted input data. If the desired result is the "ANDing" of the non-inverted input data , an inversion step may be implemented on the input signal.

A zero-power PAL circuit consumes very little power in standby-mode, i.e., when the inputs are not switching. The sense amplifier in a zero-power CMOS PAL circuit, using FAMOS technology, must have the default state of either high or low. The standard default state is low. Thus, the product line has its capacitance discharged in the default state and must be charged prior to sensing. In order to prevent the FAMOS device from entering the hot-electron region, which could cause accidental programming, the product line must clamped to under two volts.

In a previous developed sense amplifier, a $V_t$ clamp is used to limit a voltage on the product line. Hence, the product line cannot rise significantly above an N-channel $V_t$, typically about one volt. This severely limits the swing, and in turn, the speed of the sense amplifier. Further, an ITD signal is generated in response to a transition of the input signals to the FAMOS transistors. The signal becomes active on an input transition. Prior art circuits introduce delays when using the ITD signal to pull the product line high, thereby reducing the speed of the sense amplifier.

Therefore, a need has arisen in the industry to provide a high-speed pull-up circuitry for use with a sense amplifier which is compatible with zero-power circuits.

SUMMARY OF THE INVENTION

In accordance with the present invention, sensing circuitry is provided which substantially eliminates the disadvantages associated with prior sensing circuits.

The sense circuitry of present invention detects the logic state of an associated product line connected to a switching device selectively enabled by an associated control line. Detect circuitry is provided to generate a control signal responsive to a transition on the control line. Coupling circuitry is operable to couple the product line to a sensing node responsive to the control signal. Voltage control circuitry is operable to generate a predetermined voltage on the sensing node when the product line is not coupled to the sensing node.

The sensing circuit of the present invention provides several advantages over the prior art. The voltage control circuitry allows a full voltage swing of the product line, thereby improving speed. The coupling circuitry may electrically connect the sense node to the product line responsive to the control signal.

In the second embodiment of the present invention, a programmable array logic integrated circuit is provided. The programmable array logic (PAL) comprises a plurality of inputs and plurality of product lines, selectively coupled to each other by a plurality of programmable switching devices. Sensing circuitry is associated with each product line. The sensing circuitry includes a sensing node, coupling circuitry operable to electrically couple the associated product line to the sensing node responsive to a control signal, detect circuitry operable to generate a control signal responsive to a signal transition on input and voltage control circuitry operable to generate a predetermined voltage on the sensing node when the product line is not coupled to the sensing node.

BRIEF DESCRIPTION OF THE DRAWINGS

For a more complete understanding of the present invention, and the advantages thereof, reference is now made to the following descriptions taken in conjunction with the accompanying drawings, in which:

FIGURE 1 illustrates a simplified schematic representation of a programmable array logic (PAL) circuit;

FIGURE 2 illustrates a block diagram of a prior art sensing circuit;

FIGURE 3 illustrates a block diagram of a prior art sensing circuit; and

FIGURE 4 illustrates the sensing circuit of the present invention.

## DETAILED DESCRIPTION OF THE INVENTION

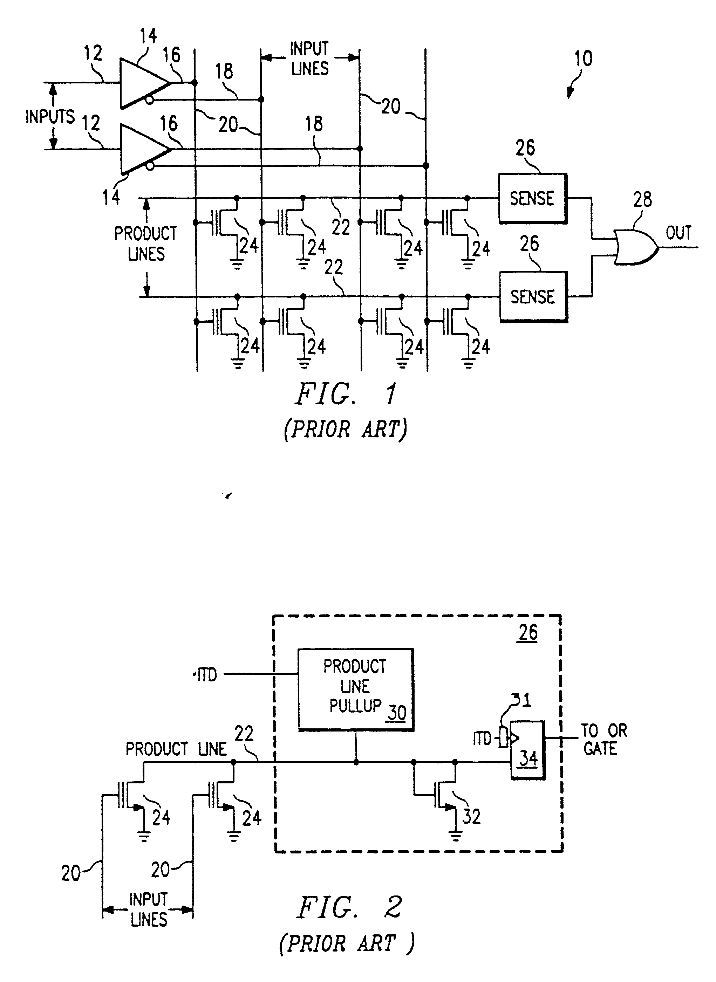

The preferred embodiment of the present invention is best understood by referring to FIGUREs 1-4 of the drawings, like numerals being used for like and corresponding parts of the various drawings.

FIGURE 1 illustrates a simplified schematic representation of a programmable array logic (PAL). The PAL 10 comprises a plurality of inputs 12 connected to input buffers 14. Input buffers 14 have true outputs 16 and false outputs 18 (the inverted input). The outputs 16 and 18 of the input buffers 14 are connected to input lines 20. Product lines 22 are connected to the input lines 20 via FAMOS transistors 24. Sense circuitry 26 is associated with each product line 22. The output of the sense circuitry 26 is input to an OR gate 28 to provide an output signal (OUT).

In operation, the FAMOS transistors 24 are programmed or erased to produce a desired logic function. A programmed FAMOS transistor will maintain a high impedance state between the product line 22 and ground irrespective of the signal on the associated input line 20. An erased FAMOS cell will act as a switch, connecting the product line 22 to ground when the FAMOS transistor 24 is addressed via the signal on its associated input line. If any one of the unprogrammed FAMOS transistors 24 is enabled, the associated product line 22 will be pulled to ground.

The sense circuitry 26 determines the logic state of the product line 22. When all of the addressed FAMOS transistors 24 associated with a product line 22 are programmed, the sense circuitry 26 pulls the product line 22 to a high level prior to determining the logic state of the product line 22. The voltage on the product line 22, however, must not be pulled above the voltage which may generate hot-electrons which could cause accidental programming.

FIGURE 2 illustrates a prior art EPAL circuit. As illustrated in FIGURE 1, FAMOS transistors 24 have gates connected to respective input lines, drains connected to a product line 22 and sources connected to ground. Sense circuitry 26 comprises a product line pull-up circuit 30 connected to the product line 22 and receiving an ITD (input transition detector) signal which has been delayed by delay circuitry 31. The ITD signal is generated in response to a change in signal on one of the inputs 12 and is typically a pulse of predetermined length. A N-channel transistor 32 has its gate and drain connected to the product line 22 and its source connected to ground. A latch 34 has its input connected to the product line 22, its clock connected to the delayed ITD signal and its output connected to the OR gate 28.

The N-channel transistor 32 provides a $V_t$ clamp, since the transistor 32 will provide a path-to-ground when its gate, connected to the product line 22, is one $V_t$ above ground. This severely limits the swing of the product line 22 and in turn, the speed of the device. The product line pull-up circuitry 30 pulls the product line 22 to one $V_t$ or higher when all of the FAMOS transistors 24 are disabled. Because a default state of a low logic level is used, the product line 22, which is highly capacitive, must be charged prior to reading the product line 22. This results in a further speed penalty.

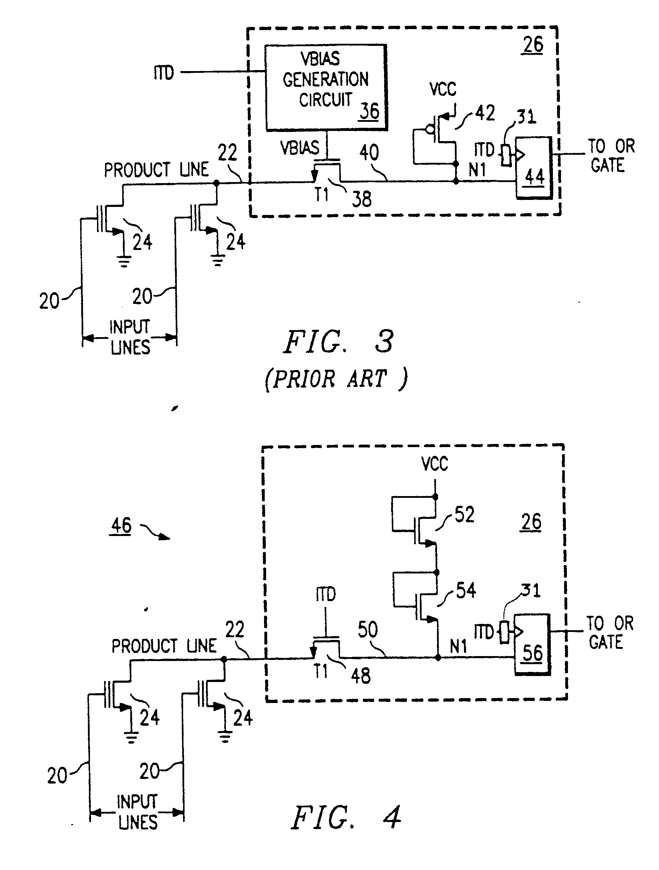

FIGURE 3 illustrates another prior art EPAL circuit. Once again, FAMOS transistors are connected to the product line 22 and the input lines 20. The ITD signal is connected to a $V_{bias}$ generation circuit 36 which outputs a $V_{bias}$ signal to the gate of an N-channel transistor 38. One source/drain region of the N-channel transistor 38 is connected to the product line 22 and the other source/drain region of the N-channel transistor 38 is connected to a sense node 40. A P-channel transistor 42 has its gate and drain connected to the sense node 40 and its source connected to $V_{cc}$. The sense node 40 is connected through the delay circuit 31 to the input of a latch 44. The ITD signal is also connected to the clock port of the latch 44 and the output of the latch 44 is connected to the OR gate 28.

In operation, the $V_{bias}$ signal is low during standby mode. Therefore, the sense node 40 remains in a high state during standby mode, since the P-channel transistor 42 will pull it to within one $V_t$ of $V_{cc}$. When the ITD signal goes active, $V_{bias}$ is set to an intermediate value between high and low, thereby producing a resistance between the product line 22 and sense node 40. The product line is thus clamped at $V_{bias} - V_t$.

This technique has two main disadvantages. The ITD pulse does not go directly to the N-channel transistor 38. Since there is a delay in setting the $V_{bias}$ signal level, the speed of the circuit is reduced. Also, since the gate of the N-channel transistor 38 does not go directly to the high rail, a large resistor is in series with the pull-up transistor 42 charging the product line, resulting in an additional speed penalty.

FIGURE 4 illustrates the PAL circuit 46 of the present invention. Once again, FAMOS transistors 24 have gates connected to the input lines 20, drains connected to the product lines 22 and sources connected to ground. A N-channel transistor 48 has its gate connected to the ITD signal, a first source/drain region connected to the product line 22 and a second source/drain region connected to a sense node 50. An N-channel transistor 52 has its gate and a first source/drain region connected to $V_{cc}$ and a second source/drain region connected to the gate and first source/drain region of an N-channel transistor 54. The second source/drain region of the N-channel transistor 54 is connected to the sense node 50. The sense node is also connected to the input of a latch 56, which is clocked by the ITD signal which has been delayed by delay circuit 31. The output of the latch 56 is connected to the OR gate 28.

In operation, the N-channel transistors 52 and 54 pull the sense node 50 to above two volts ($V_{cc}$ - $2*V_t$ -body effects). The two-volt swing is the maximum desired for the product line 22; however, the voltage may be set as desired by adjusting the number of N-channel transistors and their threshold voltages.

After an input transition, the ITD signal goes to a full high, which allows charge-sharing between the sense node 50 and the product line 22 through the N-channel transistor 48. The product line 22 is thus pulled high by a node which is already charged. If the product line is at a logical "0" (i.e., one of the FAMOS transistors 24 is enabled), it will quickly discharge the sense node 50. Since the pull-up transistors 52 and 54 are always on, there is no speed penalty in a zero-power device versus a full-power device.

While the present invention has been described in connection with an EPAL, the invention could be used on any zero-power logic device using FAMOS technology, including gate arrays and programmable sequence generators.

The present invention provides the technical advantage of increased speed in a zero-power device without increasing the possibility of hot-electron injection into the FAMOS transistors 24.

Although the present invention has been described in detail, it should be understood that various changes, substitutions and alterations can be made herein without departing from the spirit and scope of the invention as defined by the appended claims.

## Claims

1. Sense circuitry for detecting the logic state of an associated product line connected to a switching device selectively enabled by an associated control line, comprising:
   detect circuitry operable to generate a control signal responsive to a signal transition on said control line;
   a sensing node;
   coupling circuitry connected to the detect circuitry to couple the product line to said sensing node responsive to said control signal; and
   voltage control circuitry operable to generate a predetermined voltage on said sensing node when the product line is not coupled to said sensing node.

2. The sensing circuitry of Claim 1 wherein the switching device comprises a non-volatile memory cell.

3. The sensing circuitry of Claim 2 wherein said non-volatile memory cell comprises a FAMOS transistor.

4. The sensing circuitry of Claim 1 wherein said coupling circuitry comprises an N-channel transistor.

5. The sensing circuitry of Claim 1 wherein said detect circuitry is operable to generate a voltage pulse responsive to said control line transition.

6. The sensing circuitry of Claim 5 wherein said coupling circuitry comprises an N-channel transistor having a gate coupled to said detect circuitry, a first source/drain region connected to said product line and a second source/drain region connected to said sensing node.

7. The sensing circuitry of Claim 1 and further comprising latching circuitry coupled to said sensing node to store a logic value responsive to said control signal.

8. The sensing circuitry of Claim 1 wherein said voltage control circuitry comprises first and second N-channel transistors having source/drain regions connected in series.

9. The sensing circuitry of Claim 8 wherein said first N-channel transistor has a first source/drain region and a gate connected to a voltage source and a second source/drain region connected to a first source/drain regions of said second N-channel transistor and said second N-channel transistor having a gate connected to the first source/drain region and a second source/drain region connected to said sensing node.

10. The sensing circuitry of Claim 1 and further comprising a plurality of switching devices connected to said product line.

11. A method of sensing the logic state of a product line connected to a switching device selectively enabled by an associated control line, comprising:

generating a control signal responsive to a signal transition on the control line;

coupling the product line to a sensing node responsive to said control signal; and

generating a voltage on the sensing node when the sensing node is not coupled to the product line.

12. The method of Claim 11 wherein said coupling step comprises enabling a N-channel transistor having respective source/drain regions coupled to the sensing node and the product line.

13. The method of Claim 11 wherein said step of generating a control signal comprises the step of generating a voltage pulse responsive to a control line transition.

14. The method of Claim 11 and further comprising the step of storing a logic value responsive to the control signal.

15. The method of Claim 11 wherein the switching devices comprise non-volatile memory devices.

16. A programmable array logic integrated circuit comprising:

a plurality of inputs;

a plurality of product lines;

a plurality of programmable switching devices selectively coupling each product line to a voltage source responsive to a respective input; and

sensing circuitry associated with each product line, said sensing circuitry comprising:

detect circuitry operable to generate a control signal responsive to a signal transition on an input;

a sensing node;

coupling circuitry connected to the detect circuitry operable to electrically couple the associated product line to said sensing

node responsive to said control signal; and

voltage control circuitry operable to generate a predetermined voltage on said node when the product line is not coupled to said sensing node.

17. The programmable array logic of Claim 16 wherein said switching devices comprise non-volatile memories.

18. The programmable array logic of Claim 17 wherein said non-volatile memories comprise FAMOS transistors.

19. The programmable array logic of Claim 16 wherein said coupling circuitry comprises an N-channel transistor having its gate connected to said detect circuitry.

20. The programmable array logic of Claim 16 wherein said voltage control circuitry comprises first and second N-channel transistors having source/drain regions connected in series.

21. The programmable array logic of Claim 16 wherein said first N-channel transistor has a first source/drain region and a gate connected to a voltage source and a second source/drain region connected to a first source/drain region of said second N-channel transistor and said second N-channel transistor has a gate connected to the first source/drain region and a second source/drain region connected to said sensing node.

FIG. 1
(PRIOR ART)

FIG. 2
(PRIOR ART )

FIG. 3
(PRIOR ART )

FIG. 4

7